# EUROPÄISCHE PATENTSCHRIFT

(11) **EP 0 901 713 B1**
(45) Veröffentlichungstag und Bekanntmachung des Hinweises auf die Patenterteilung: **19.04.2000**
(21) Anmeldenummer: 97925866.2
(22) Anmeldetag: 23.05.1997
(51) Int. Cl.: H03B 28/00

(54) **GENERATOR ZUR ERZEUGUNG EINES RAUSCHARMEN SIGNALS HOHER FREQUENZ**
GENERATOR FOR PRODUCING A HIGH-FREQUENCY, LOW-NOISE SIGNAL
GENERATEUR POUR LA PRODUCTION D'UN SIGNAL HAUTE FREQUENCE A FAIBLE BRUIT

(30) Priorität: 30.05.1996 DE 19621600
(43) Veröffentlichungstag der Anmeldung: 17.03.1999
(73) Patentinhaber: Deutsche Telekom AG, 53113 Bonn (DE)
(72) Erfinder: BURKHARD, Herbert, D-64297 Darmstadt (DE); SCHÖLL, Hansjörg, D-64367 Mühltal (DE); TAMBURRINI, Mario, I-00142 Roma (IT)
(86) Internationale Anmeldenummer: DE9701054
(87) Internationale Veröffentlichungsnummer: WO9747080

(56) Entgegenhaltungen:
- WO-A-93/16514
- US-A- 5 153 888
- WAKE D ET AL: "OPTICAL GENERATION OF MILLIMETER-WAVE SIGNALS FOR FIBER-RADIO SYSTEMS USING A DUAL-MODE DFB SEMICONDUCTOR LASER" IEEE TRANSACTIONS ON MICROWAVE THEORY AND TECHNIQUES, Bd. 43, Nr. 9, PART 02, 1.September 1995, Seiten 2270-2276, XP000524215 in der Anmeldung erwähnt
- DALMA NOVAK ET AL: "SIGNAL GENERATION USING PULSED SEMICONDUCTOR LASERS FOR APPLICATION IN MILLIMETER-WAVE WIRELESS LINKS" IEEE TRANSACTIONS ON MICROWAVE THEORY AND TECHNIQUES, Bd. 43, Nr. 9, PART 02, 1.September 1995, Seiten 2257-2262, XP000524213 in der Anmeldung erwähnt
- TROMMEL, KAISER, STENZEL, HEIDRICH: "Multi-Purpose Dual Tunable Laser/Combiner PIC Based on InP" PROCEEDINGS OF THE 21STEUROPEAN CONFERENCE ON OPTICAL COMMUNICATIONS, ECOC'95, Bd. 1, 17. - 21.September 1995, GENT, BELGIEN, Seiten 83-86, XP002041048 in der Anmeldung erwähnt
- GOLDBERG, YUREK, TAYLOR, WELLER: "35 GHZ MICROWAVE SIGNAL GENERATION WITH AN INJECTION-LOCKED LASER DIODE" ELECTRONICS LETTERS, Bd. 21, Nr. 18, 29.August 1985, UK, Seiten 814-815, XP002041049 in der Anmeldung erwähnt

## Beschreibung

### Technisches Gebiet

Die Erfindung betrifft einen Generator zur Erzeugung eines rauscharmen Signals hoher Frequenz, wobei ein einwelliger erster Laser über eine optische Einwegleitung mit einem zweiten Laser derart verbunden ist und vom ersten Laser erzeugtes Licht dem zweiten Laser injiziert wird.

In Funksystemen mit Mikrowellen werden Trägerfrequenzen im Bereich von 10 GHz und mehr benötigt. Solche Funksysteme werden beispielsweise zur Ergänzung von fest verkabelten Teilnehmeranschlüssen als sogenannte WLL (= Wireless Local Loop) angewendet. Diese Systeme sind geeignet, Kunden schnell, flexibel und zu geringen Kosten mit neuen Kommunikationsdiensten zu versorgen.

### Stand der Technik

Zur Erzeugung von Trägern hoher Frequenz sind bereits verschiedene Lösungen bekanntgeworden. So ist beispielsweise das Einrasten eines Fabry-Perot-Lasers auf ein injiziertes Seitenband aus L. Goldberg, A.M. Yurek, H.F. Taylor, and J.F. Weller, "35 GHz microwave signal generation with an injection-locked laser diode", Electron. Lett., vol. 21, pp. 630631, 1985 bekanntgeworden. Auch ein hochfrequenzgetriebener Zweimoden-Laser mit verteilter Rückkopplung wurde in D. Wake, C.R. Lima, and P.A. Davies, "Optical generation of millimeter-wave signals for fiber-radio systems using a dual-mode DFB semiconductor laser", IEEE Trans. Microwave Theory and Techn., vol. 43, pp. 2270-2276, 1995 beschrieben. Ferner ist ein optisch gefiltertes Moden-Einrasten von Laserdioden aus D. Novak, Z. Ahmed, R.B. Waterhouse, and R.S. Tucker, "Signal generation using pulsed semiconductor lasers for application in millimeter-wave wireless links", IEEE Trans. Microwave Theory and Techn., vol. 43, pp. 2257-2262, 1995 bekannt.

Außerdem wurde die Überlagerung von zwei unabhängigen Laser-Linien in D. Trommer, R. Kaiser, R. Stenzel, H. Heidrich, "Multi-Purpose Laser/Combiner PIC Based in InP", Proc ECOC '95, paper Mo.B.4.2, pp. 83-86, 1995 beschrieben.

Die bekannten Verfahren besitzen verschiedene Nachteile. Sie benötigen entweder zusätzlich elektrische Mikrowelleneinstrahlung oder rauschen zu stark für die Anwendung in Funksystemen. Eine kontinuierliche Durchstimmung der erzeugten optischen Mikrowellenfrequenzen ist nur beim Gegenstand der letztgenannten Veröffentlichung möglich, dafür ist aber das Rauschen bei diesem Verfahren sehr stark.

Es ist ferner aus WO 93/16514 A1 eine Einrichtung zur Änderung der Frequenz von Lichtsignalen bekannt, bei welcher ein Quellenlichtsignal einem Eingang einer selbst pulsierenden Laserdiode zugeführt wird. Dabei stimmt die Frequenz der Laserdiode mit derjenigen des Quellensignals oder einer Harmonischen desselben überein. Die Anordnung dient dazu, verschiedene Modulationsfrequenzen des vom Laser abgestrahlten Lichtes zu erzeugen.

### Darstellung der Erfindung

Aufgabe der vorliegenden Erfindung ist es daher, einen Generator anzugeben, der mit möglichst geringem Aufwand einen Träger oder ein sonstiges Signal hoher Frequenz erzeugt, das weitgehend rauscharm ist.

Diese Aufgabe wird erfindungsgemäß dadurch gelöst, daß die Differenz der Frequenzen der Laser und die Intensität des injizierten Lichts derart gewählt werden, daß der zweite Laser nicht auf die freilaufende Frequenz des ersten Lasers einrastet, daß der zweite Laser auf einer gegenüber der freilaufenden Frequenz geringfügig verschiedenen Frequenz schwingt und sein Ausgangssignal eine große Modulationstiefe aufweist mit einer Modulationsfrequenz von etwa der Frequenzdifferenz der beiden freilaufenden Laser.

Eine vorteilhafte Ausgestaltung des erfindungsgemäßen Generators besteht darin, daß der erste Laser ein Laser mit externem Resonator (ECL = External Cavity Laser) ist. Dadurch ist eine gute Durchstimmbarkeit der erzeugten Frequenz möglich. Für Anwendungen, bei denen eine solche Durchstimmbarkert, insbesondere ein größerer Abstimmbereich, nicht erforderlich ist, ist jedoch im Rahmen der Erfindung als erster Laser auch ein anderer Laser geeignet, beispielsweise ein Laser mit verteilter Rückkopplung.

Eine weitere vorteilhafte Ausgestaltung des erfindungsgemäßen Generators besteht darin, daß der zweite Laser ein Laser mit verteilter Rückkopplung (DFB = Distributed Feedback) ist.

Zur Erzeugung einer Trägerfrequenz für Mikrowellen-Funksysteme ist bei einer Weiterbildung des erfindungsgemäßen Generators vorgesehen, daß an dem Ausgang des zweiten Lasers ein photoelektrischer Wandler angeschlossen ist, wobei vorzugsweise der Ausgang des zweiten Lasers und der Eingang des photoelektrischen Wandlers über eine optische Einwegleitung verbunden sind.

Bei dieser Ausführungsform des erfindungsgemäßen Generators kann die Modulation des Trägers auf der elektrischen Ebene erfolgen. Es kann jedoch auch vorgesehen sein, daß dem photoelektrischen Wandler ein optischer Modulator vorgeschaltet ist. Damit ist es möglich, das bereits modulierte Mikrowellensignal mit Lichtwellenleiter über große Strecken verlustarm zu transportieren und erst am Ort der Abstrahlung in ein elektrisches Signal umzuwandeln.

Ein weiteres Anwendungsgebiet des erfindungsgemäßen Generators ist die Erzeugung von extrem hochfrequenten zu modulierenden Signalen, die optisch übertragen werden. Dazu kann der erfindungsgemäße Generator derart ausgebildet sein, daß der erste Laser mit einer der Frequenz des Signals entsprechenden Frequenz moduliert ist, daß der zweite Laser auf ein durch die Modulation gegebenes Seitenband einrastet und daß das Ausgangssignal des zweiten Lasers mit einem digitalen Modulationssignal modulierbar ist, dessen Takt der Frequenz entspricht, mit welcher der erste Laser moduliert ist. Das Ausgangssignal des zweiten Lasers ist somit synchronisiert mit der Frequenz, mit welcher der erste Laser moduliert ist. Vorzugsweise ist dabei vorgesehen, daß das modulierte Ausgangssignal des zweiten Lasers einer optischen Übertragungseinrichtung zuführbar ist.

Gemäß einer anderen Ausgestaltung der Erfindung kann eine Modulation des zu erzeugenden Signals dadurch erfolgen, daß das Ausgangssignal des ersten Lasers mit einem zugeführten Signal moduliert wird, so daß auch das zu erzeugende Signal mit dem zugeführten Signal moduliert ist. Die Modulation des Ausgangssignals des ersten Lasers kann auch zusätzlich zur Modulation mit einer einzelnen Seitenbandfrequenz erfolgen.

Diese Ausgestaltung kann derart ausgebildet sein, daß der erste Laser direkt moduliert wird oder daß zur Modulation ein externer optischer Modulator vorgesehen ist. Die Modulation kann sowohl mit analogen als auch mit digitalen Signalen erfolgen.

Alternativ kann zur Erzeugung von extrem hochfrequenten optischen Signalen vorgesehen sein, daß das Ausgangssignal des zweiten Lasers einem optischen Modulator und einem Taktgenerator für ein digitales Modulationssignal für den optischen Modulator zuführbar ist.

Die Erfindung nutzt in vorteilhafter Weise eine Eigenschaft des zweiten Lasers aus, nämlich die Erzeugung einer weiteren Frequenz außer einer etwa der Eigenfrequenz des zweiten Lasers entsprechenden Frequenz. Diese weitere Frequenz entsteht dann, wenn die Differenzfrequenz der beiden Laser größer als der Einrastbereich (Locking-Bereich) gewählt wird. Die Ursache dafür ist eine Änderung (Ziehen) der mittleren optischen Frequenz des Feldes des zweiten Lasers durch Injektion. Sowohl für positive als auch für negative Frequenzdifferenzen können Oszillationsfrequenzen des Ausgangssignals des zweiten Lasers von 7 GHz bis über 2 THz auftreten. Bei einer praktischen Anwendung werden jedoch nur Frequenzen bis 45 GHz gemessen bedingt durch die Bandbreite eines angeschlossenen photoelektrischen Wandlers. Die Linienbreite an den (-3dB)-Punkten liegt unterhalb von 100 kHz bei Verwendung eines ECL als erstem Laser. Mit Hilfe eines Interferometers und der Erzeugung der zweiten Harmonischen (SHG) wurden Frequenzen bis zu 2 THz gemessen, die einen Modulationsindex von 90% hatten.

### Kurze Beschreibung der Zeichnungen

Ausführungsbeispiele der Erfindung sind in der Zeichnung anhand mehrerer Figuren dargestellt und in der nachfolgenden Beschreibung näher erläutert. Es zeigt:
- Fig. 1: ein Ausführungsbeispiel, das zur Erzeugung eines Mikrowellenträgers ausgelegt ist,
- Fig. 2: ein weiteres Ausführungsbeispiel zur Erzeugung eines Mikrowellenträgers,
- Fig. 3: ein Ausführungsbeispiel zur Erzeugung eines hochfrequenten optischen Signals,
- Fig. 4: ein weiteres Ausführungsbeispiel zur Erzeugung eines hochfrequenten optischen Signals,
- Fig. 5: einen als Versuchsanordnung aufgebauten erfindungsgemäßen Generator,
- Fig. 6: ein Ausführungsbeispiel zur Erzeugung eines modulierten Mikrowellenträgers,
- Fig. 7: ein weiteres Ausführungsbeispiel zur Erzeugung eines modulierten Mikrowellenträgers,
- Fig. 8: eine Darstellung des Einrastverhaltens des zweiten Lasers,
- Fig. 9: den Amplitudenverlauf des erzeugten optischen Signals und
- Fig. 10: den Frequenzverlauf.

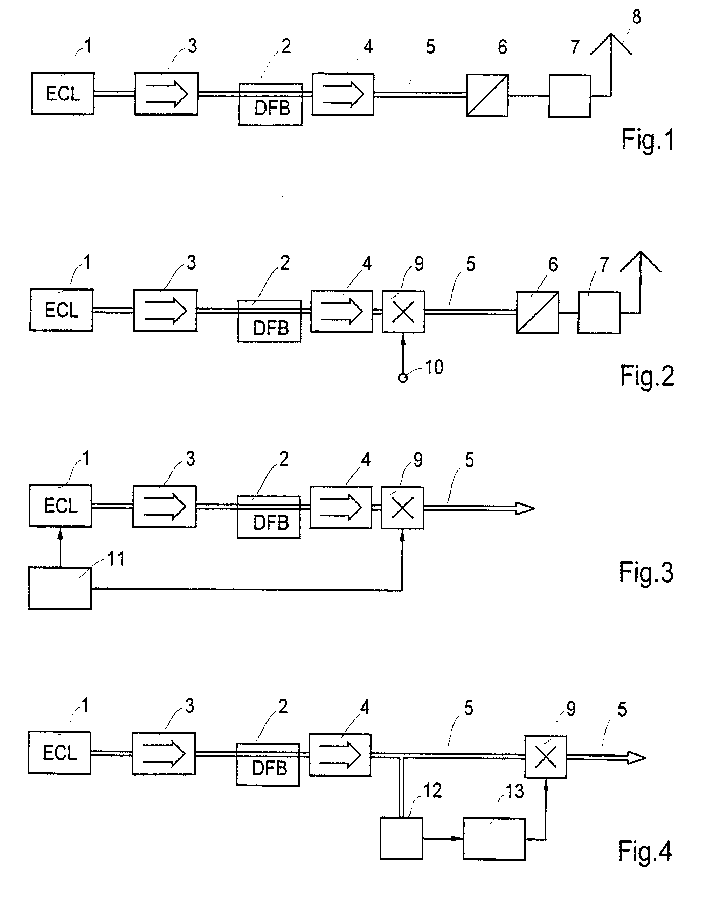

Gleiche Teile sind in den Figuren mit gleichen Bezugszeichen versehen. In den als Blockschaltbilder ausgeführten Figuren 1 bis 7 sind optische Verbindungen in Form von Doppellinien und elektrische Verbindungen in Form von einzelnen Linien dargestellt.

### Wege zur Ausführung der Erfindung

Bei allen dargestellten Ausführungsbeispielen wird das Ausgangssignal eines Lasers 1 mit externem Resonator über eine optische Einwegleitung 3 einem DFB-Laser 2 zugeleitet, so daß der Laser 1 als Mutter-Laser und der DFB-Laser 2 als Tochter-Laser betrieben wird. An der der Einkopplungs-Laser-Facette des Tochter-Lasers 2 gegenüberliegenden Seite wird das Ausgangssignal dieses Lasers ausgekoppelt und über eine weitere optische Einwegleitung 4 und einen Lichtleiter 5 einem photoelektrischen Wandler 6 zugeführt, an dem ein Sender 7 mit einer Antenne 8 angeschlossen ist.

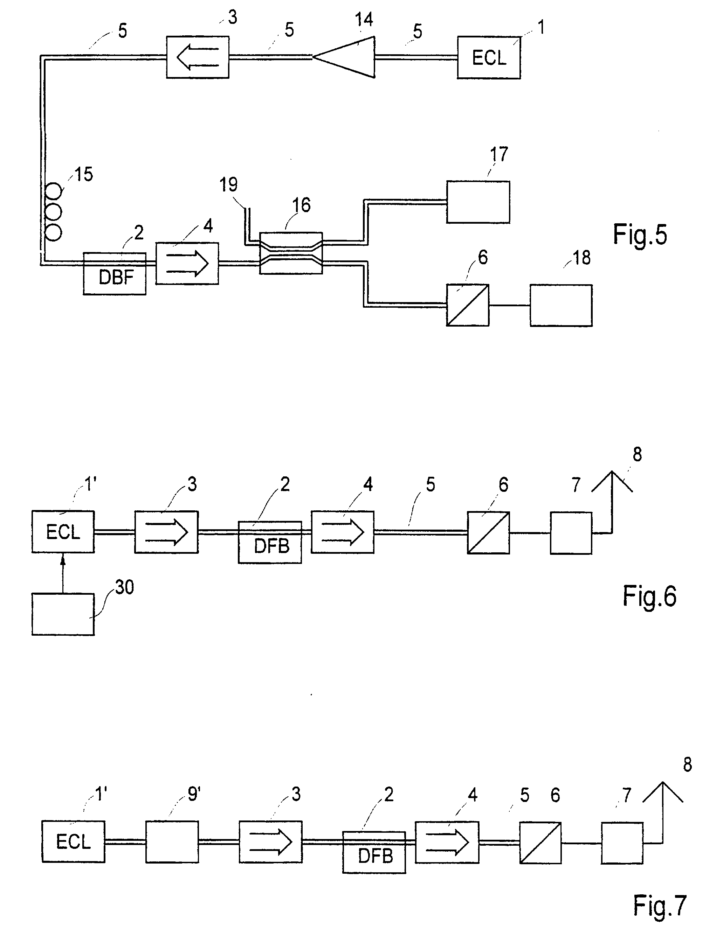

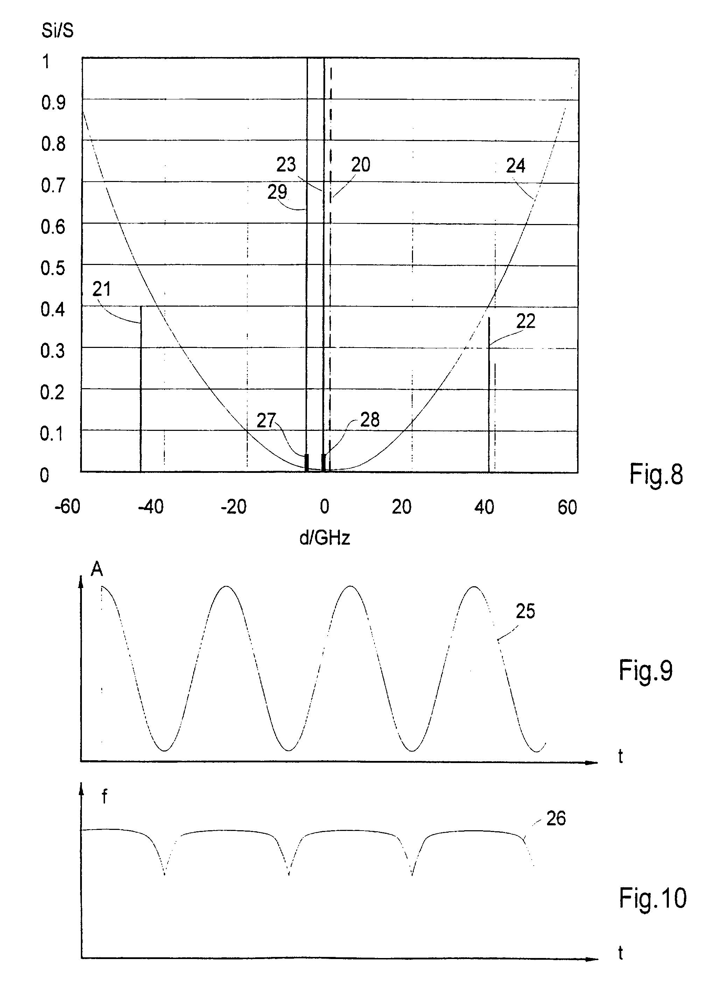

Die Funktion des in Fig. 1 dargestellten Generators wird im folgenden anhand der Figuren 6 bis 8 erläutert. Fig. 8 zeigt die Abhängigkeit des zum Einrasten des Tochter-Lasers 2 auf die Frequenz des Mutter-Lasers 1 erforderlichen Injektionsverhältnisses. Das Injektionsverhältnis Si/S ist das Verhältnis zwischen der Anzahl der injizierten Photonen zu der Anzahl der im Resonator des Tochter-Lasers 2 vorhandenen Photonen. Oberhalb der Kurve 24 rastet der Tochter-Laser auf die Frequenz des Mutter-Lasers ein. Je größer die Frequenzdifferenz ist, desto größer ist das zum Einrasten erforderliche Injektionsverhältnis.

Das Diagramm umfaßt einen Bereich des Injektionsverhältnisses von 0 bis 1 und einen Bereich der Frequenzdifferenz von -60 GHz bis +60 GHz bezogen auf die Frequenz des freilaufenden Tochter-Lasers von beispielsweise 200 THz, die durch eine gestrichelte senkrechte Linie bei d=0 dargestellt ist. Erfolgt nun eine Injektion mit einer Frequenz des Mutter-Lasers, die um -44 GHz kleiner als die Frequenz des freilaufenden Tochter-Lasers ist (siehe Linie 21) oder die um 38 GHz größer ist (Linie 22), so erfolgt kein Einrasten des Tochter-Lasers, wenn das Injektionsverhältnis kleiner als etwa 0,4 ist. Die sich einstellende Oszillationsfrequenz ist in beiden Fällen 40 GHz.

Der Tochter-Laser schwingt dann auf einer Frequenz, die geringfügig kleiner als die des freilaufenden Tochter-Lasers ist. Im Falle einer injizierten Frequenz 22 schwingt der Tochter-Laser mit der Frequenz 23, im Falle einer injizierten Frequenz 21 mit der Frequenz 29. Das Ausgangssignal mit dieser Frequenz ist - wie aus Fig. 9 ersichtlich - moduliert, und zwar mit einer Frequenz von 40 GHz, die etwa der Frequenzdifferenz d der freilaufenden Laser entspricht. Liegen die Frequenzdifferenz und das Injektionsverhältnis auf einem Punkt nahe der Grenze 24 des Einrastbereichs, so ergibt sich eine große Modulationstiefe von praktisch 100%, wie der Verlauf 25 der Amplitude A in Fig. 9 zeigt. Die Frequenz 23 des Tochter-Lasers ist dabei recht stabil und ändert sich nur geringfügig in den Zeitbereichen, wenn die Photonendichte im Laser 2 nahe bei null ist (Fig. 10, Kurve 26).

Entscheidend ist bei dem Signal 25, daß es äußerst geringes Phasenrauschen aufweist. Führt man nun dieses optische Signal dem photoelektrischen Wandler 6 (Fig. 1) zu, so liefert dieser ein Ausgangssignal mit der entsprechenden Frequenz und ebenfalls mit äußerst geringem Phasenrauschen. Dieses Signal kann dann im Sender 7 in geeigneter Weise moduliert und über die Antenne 8 abgestrahlt werden.

Bei dem Ausführungsbeispiel nach Fig. 2 erfolgt die Erzeugung des rauscharmen Signals wie bei dem Generator nach Fig. 1. Die Modulation mit einem bei 10 zugeführten Signal erfolgt jedoch bereits in einem optischen Modulator 9 auf der optischen Ebene. Das bereits modulierte optische Signal kann dann über ein optisches Leitungsnetz (in Fig. 2 durch eine einzelne Leitung 5 dargestellt) an gegebenenfalls mehrere photoelektrische Wandler 6 verteilt werden, an die jeweils ein Sender 7 und eine Antenne 8 angeschlossen ist.

Bei dem Ausführungsbeispiel nach Fig. 3 wird der Mutter-Laser 1 mit der Taktfrequenz eines bei 11 erzeugten digitalen Signals moduliert, mit dem das optische Ausgangssignal moduliert wird. Die Modulation des Mutter-Lasers 1, beispielsweise amplitudenmoduliert mit einem Hub von etwa 0,1% über den Injektionsstrom oder durch externe Intensitätsmodulation, hat Seitenbänder im Abstand der Frequenz des Taktsignals vom Träger 21 oder 22 (Fig. 8) zur Folge, wovon nur jeweils ein Seitenband 27, 28 in Fig. 8 dargestellt ist. Der Übersichtlichkeit halber wurden die Amplituden der Seitenbänder 27, 28 im Verhältnis zu den Amplituden der Träger 21, 22 vergrößert dargestellt.

Da in der Nähe der Frequenz des freilaufenden Tochter-Lasers 2 eine äußerst geringe Injektion genügt, um den Tochter-Laser einzurasten, wird nur ein geringer Modulationsgrad des Mutter-Lasers benötigt, um ein Einrasten des Tochter-Lasers auf das jeweilige Seitenband 27 oder 28 zu bewirken. Damit kann das Ausgangssignal des Tochter-Lasers 2 synchron moduliert werden, das heißt, von den in Fig. 7 dargestellten Wellen können je nach Informationsgehalt des Modulationssignals einzelne vom Modulator 9 unterdrückt oder hindurchgelassen werden. Das vorhandene Phasenrauschen, das in der Quelle 11 für das Modulationssignal und das Taktsignal entsteht, hat nur einen geringen Einfluß auf die Kurvenform des modulierten Signals.

Bei dem in Fig. 4 dargestellten Ausführungsbeispiel werden die Laser 1, 2 so betrieben, wie es im Zusammenhang mit den Figuren 1 und 2 bereits erläutert wurde. Der Mutter-Laser 1 ist dabei nicht moduliert. Das Ausgangssignal des Tochter-Lasers 2 wird jedoch außer dem Modulator 9 auch einem Taktgenerator 12 zugeführt, wo es zur Ableitung eines Taktsignals für die Quelle 13 für das Modulationssignal genutzt wird. Wie bei dem Ausführungsbeispiel nach Fig. 3 kann das modulierte Signal über Lichtleiter 5 verteilt werden.

Fig. 5 zeigt ebenfalls als Blockschaltbild eine Versuchsanordnung, die gegenüber den Ausführungsbeispielen um einige Lichtleiter, einen Verstärker 14, einen Polarisator 15, einen Richtkoppler 16, einen optischen Spektrumanalysator 17 und einen elektrischen Spektrumanalysator 18 erweitert ist. Der Polarisator 15 dient lediglich dazu, die in den vorgeschalteten Lichtleitern 5 erfolgte Depolarisierung aufzuheben. Bei den Ausführungsbeispielen ist ein solcher Polarisator nicht vorgesehen, da dort polarisations-erhaltende Lichtleiter verwendet werden. Mit Hilfe des Richtkopplers 16 wird das Ausgangssignal des Tochter-Lasers 2 dem optischen und über den photoelektrischen Wandler 6 auch dem elektrischen Spektrumanalysator zugeführt. Damit können gleichzeitig sowohl das optische Spektrum als auch das elektrische Spektrum des Ausgangssignals des Tochter-Lasers 2 gemessen werden. Eine PIN-Photodiode dient als photoelektrischer Wandler und weist eine Bandbreite von 45 GHz auf.

Bei einem Vorstrom des 2,7-fachen des Schwellenstroms des Tochter-Lasers 2 und bei einem Verhältnis von injizierter Leistung zur Leistung des Tochter-Lasers 2 von 0,1 bis 0,5 ist der Einrastbereich etwa 10 GHz bis 30 GHz breit, wenn die Mutter-Laserfrequenz größer als die Tochter-Laserfrequenz ist. Wenn unter diesen Bedingungen die Frequenzdifferenz der beiden Laser größer als der Einrastbereich gewählt wird, entstehen zwei getrennte Spektrallinien am Ausgang des Tochter-Lasers. Diese beiden Frequenzen erzeugen das optische Ausgangssignal. Hierbei ist die entstehende Frequenz nicht gleich der Differenzfrequenz der beiden freilaufenden Laser, wie es bereits anhand von Fig. 8 erläutert wurde. Die Ursache dafür ist eine Änderung (Ziehen) der mittleren optischen Frequenz des Tochter-Laser-Feldes durch die Injektion. Sowohl für positive als auch negative Frequenzdifferenzen (Detuning) werden Oszillationsfrequenzen des Ausgangssignals des Tochter-Lasers von 7 GHz bis 45 GHz mit einer schnellen Photodiode gemessen, was bei der in Fig. 5 dargestellten Versuchsanordnung lediglich durch die Bandbreite der PIN-Photodiode 6 begrenzt ist. Die Linienbreite an den (-3dB)-Punkten liegt unterhalb 100 kHz, wenn der Mutter-Laser ein ELC ist.

Der Beweis dafür, daß das Phasenrauschen reduziert wird, wird bei der Versuchsanordnung nach Fig. 5 durch folgende Messung erbracht: Wird der Strahlengang hinter dem optischen Verstärker 14 am Ausgang des Mutter-Lasers 1 unterbrochen und wird dieser Ausgang mit dem Anschluß 19 des Richtkopplers 16 verbunden, so kann auf dem elektrischen Spektrumanalysator 17 die normale Überlagerung der beiden freilaufenden Laser beobachtet werden. Die gemessene Linienbreite ist dann in diesem Fall 2,2 MHz, was in guter Näherung der Linienbreite des Tochter-Lasers 2 entspricht, da die Linienbreite des Mutter-Lasers 1 etwa nur 100 kHz bis 150 kHz beträgt.

Auf diese Weise wird deutlich, daß dadurch, daß das Licht des Mutter-Lasers gemeinsam mit dem Tochter-Laser-Licht durch den Resonator des Tochter-Lasers läuft, die gegenseitige Kohärenz wächst. Dieses führt zu einer geringeren Linienbreite der Oszillationsfrequenz, da beide Wellenfelder an das gleiche Reservoir von Ladungsträgern angekoppelt werden. Die Ladungsträger in diesem gemeinsamen Reservoir beeinflussen den Brechungsindex des Resonators und damit die Phasen beider Felder gemeinsam. Eine solche Korrelation ist für die beobachtete größere gegenseitige Kohärenz verantwortlich. Messungen mit Hilfe eines elektronischen Spektrumanalysators ergeben Linienbreiten der Oszillationsfrequenz von 600 Hz. Dieser geringe Wert ist aber nur durch die Eigenschaften des Generators bedingt, der im Mutter-Laser die Seitenbänder erzeugt.

Bei dem Ausführungsbeispiel nach Fig. 6 ist als Mutter-Laser ein DFB-Laser 1' vorgesehen, der von einer Quelle 30 über ein analoges elektrisches frequenz- oder phasenmoduliertes Signal angesteuert wird. Diese direkte Modulation des Lasers 1' wird in ein entsprechendes optisches Signal umgewandelt und in den Tochter-Laser 2 injiziert. Dementsprechend erzeugt der Tochter-Laser 2 ein optisches Mikrowellensignal mit derselben Modulation, das über Glasfasern übertragen werden kann.

Das Ausführungsbeispiel nach Fig. 7 umfaßt ebenfalls eine Modulation des Ausgangssignals des Mutter-Lasers 1', also des injizierten Signals. Es wird jedoch ein externer optischer Modulator 9' angewendet. Je nach Stärke der Amplituden-Phasenkopplung kann nur eine Amplitudenmodulation oder auch eine Phasen- bzw. Frequenzmodulation erfolgen. Außerdem kann mit Hilfe des externen optischen Modulators 9' auch eine Modulation mit einer für das Einrasten des Tochter-Lasers 2 auf das Seitenband, wie es im Zusammenhang mit Fig. 8 beschrieben wurde, durchgeführt werden.

Die Modulation mit dem letztlich zur Übertragung vorgesehenen Modulationssignal kann analog oder digital erfolgen. Durch die Modulation gemäß dem Ausführungsbeispiel nach Fig. 7 wird ein äußerst phasenstabiler optischer Träger erzeugt, der eine analoge oder digitale Modulation enthält. Die externe Amplitudenmodulation kann hierbei in eine Frequenz- oder Phasenmodulation umgesetzt werden.

## Patentansprüche

1. Generator zur Erzeugung eines rauscharmen Signals hoher Frequenz, wobei ein einwelliger erster Laser (1) über eine optische Einwegleitung (3) mit einem zweiten Laser (2) derart verbunden ist und vom ersten Laser (1) erzeugtes Licht dem zweiten Laser (2) injiziert wird, dadurch gekennzeichnet, daß die Differenz der Frequenzen der Laser (1, 2) und die Intensität des injizierten Lichts derart gewählt werden, daß der zweite Laser (2) nicht auf die freilaufende Frequenz des ersten Lasers (1) einrastet, daß der zweite Laser (2) auf einer gegenüber der freilaufenden Frequenz geringfügig verschiedenen Frequenz schwingt und sein Ausgangssignal eine große Modulationstiefe aufweist mit einer Modulationsfrequenz von etwa der Frequenzdifferenz der beiden freilaufenden Laser.

2. Generator nach Anspruch 1, dadurch gekennzeichnet, daß der erste Laser (1) ein Laser mit externem Resonator ist.

3. Generator nach einem der vorhergehenden Ansprüche, dadurch gekennzeichnet, daß der zweite Laser (2) ein Laser mit verteilter Rückkopplung ist.

4. Generator nach einem der vorhergehenden Ansprüche, dadurch gekennzeichnet, daß an dem Ausgang des zweiten Lasers (2) ein photoelektrischer Wandler (6) angeschlossen ist.

5. Generator nach Anspruch 4, dadurch gekennzeichnet, daß der Ausgang des zweiten Lasers (2) und der Eingang des photoelektrischen Wandlers (6) über eine optische Einwegleitung (4) verbunden sind.

6. Generator nach einem der Ansprüche 4 oder 5, dadurch gekennzeichnet, daß dem photoelektrischen Wandler (6) ein optischer Modulator (9) vorgeschaltet ist.

7. Generator nach einem der Ansprüche 1 bis 3, dadurch gekennzeichnet, daß der erste Laser (1) mit einer der Frequenz des Signals entsprechenden Frequenz moduliert ist, daß der zweite Laser (2) auf ein durch die Modulation gegebenes Seitenband einrastet und daß das Ausgangssignal des zweiten Lasers (2) mit einem digitalen Modulationssignal modulierbar ist, dessen Takt der Frequenz entspricht, mit welcher der erste Laser (1) moduliert ist.

8. Generator nach Anspruch 7, dadurch gekennzeichnet, daß das Ausgangssignal des ersten Lasers (1') ferner mit einem zugeführten Signal moduliert wird, so daß auch das zu erzeugende Signal mit dem zugeführten Signal moduliert ist.

9. Generator nach einem der Ansprüche 1 bis 3, dadurch gekennzeichnet, daß das Ausgangssignal des ersten Lasers (1') mit einem zugeführten Signal moduliert wird, so daß auch das zu erzeugende Signal mit dem zugeführten Signal moduliert ist.

10. Generator nach einem der Ansprüche 8 oder 9, dadurch gekennzeichnet, daß der erste Laser (1') direkt moduliert wird.

11. Generator nach einem der Ansprüche 8 oder 9, dadurch gekennzeichnet, daß zur Modulation ein externer optischer Modulator (9') vorgesehen ist.

12. Generator nach einem der Ansprüche 6 bis 11, dadurch gekennzeichnet, daß das modulierte Ausgangssignal des zweiten Lasers (2) einer optischen Übertragungseinrichtung (5) zuführbar ist.

13. Generator nach einem der Ansprüche 1 bis 3, dadurch gekennzeichnet, daß das Ausgangssignal des zweiten Lasers (2) einem optischen Modulator (9) und einem Taktgenerator (12) für ein digitales Modulationssignal für den optischen Modulator (9) zuführbar ist.

## Claims

1. Generator for generating a high-frequency, low-noise signal, a single-frequency first laser (1) so being connected by an optical one-way isolator (3) to a second laser (2) and light produced by the first laser (1) being injected to the second laser (2), characterized in that the difference of the frequencies of the lasers (1, 2) and the intensity of the injected light are selected such that the second laser (2) does not lock onto the free-running frequency of the first laser (1), wherein the second laser (2) oscillates on a frequency slightly different from the free-running frequency and its output signal has a large modulation depth with a modulation frequency of approximately the frequency difference of the two free-running lasers.

2. Generator according to claim 1, characterized in that the first laser (1) is a laser with external resonator.

3. Generator according to any one of the preceding claims, characterized in that the second laser (2) is a laser with distributed feedback.

4. Generator according to any one of the preceding claims, characterized in that a photoelectric transducer (6) is connected at the output of the second laser (2).

5. Generator according to claim 4, characterized in that the output of the second laser (2) and the input of the photoelectric transducer (6) are connected by an optical one-way isolator (4).

6. Generator according to any one of claim 4 or 5, characterized in that an optical modulator (9) is connected upstream to the photoelectric transducer (6).

7. Generator according to any one of claims 1 to 3, characterized in that the first laser (1) is modulated with a frequency corresponding to the frequency of the signal, wherein the second laser (2) locks onto a sideband given by the modulation and the output signal of the second laser (2) is adapted to be modulated with a digital modulation signal the timing of which corresponds to the frequency with which the first laser (1) is modulated.

8. Generator according to claim 7, characterized in that the output signal of the first laser (1') is further modulated with a supplied signal, with the result that also the signal to be generated is modulated with the supplied signal.

9. Generator according to any one of claims 1 to 3, characterized in that the output signal of the first laser (1') is modulated with a supplied signal, with the result that the signal to be generated is also modulated with the supplied signal.

10. Generator according to any one of claim 8 or 9, characterized in that the first laser (1') is directly modulated.

11. Generator according to any one of claim 8 or 9, characterized in that an external optical modulator (9') is provided for modulation.

12. Generator according to any one of claims 6 to 11, characterized in that the modulated output signal of the second laser (2) is adapted to be supplied to an optical transmission apparatus (5).

13. Generator according to any one of claims 1 to 3, characterized in that the output signal of the second laser (2) is adapted to be supplied to an optical modulator (9) and to a timing-pulse generator (12) for a digital modulation signal for the optical modulator (9).

## Revendications

1. Générateur d'un signal à haute fréquence à faible bruit, dans lequel un premier laser monochromatique (1) est relié par un circuit optique demi-onde (3) à un deuxième laser (2), la lumière générée par le premier laser (1) étant injectée au deuxième laser (2), caractérisé en ce que la différence entre les fréquences des lasers (1, 2) et l'intensité de la lumière injectée sont telles que le deuxième laser (2) ne s'enclenche pas sur la fréquence libre du premier laser (1), que le deuxième laser (2) vibre à une fréquence s'écartant peu de la fréquence libre et que son signal de sortie présente une forte profondeur de modulation, avec une fréquence de modulation correspondant à peu près à la différence de fréquence entre les deux lasers libres.

2. Générateur selon revendication 1, caractérisé en ce que le premier laser (1) est un laser à cavité externe.

3. Générateur selon l'une ces revendications précédentes, caractérisé en ce que le deuxième laser (2) est un laser à réinjection distribuée.

4. Générateur selon l'une des revendications précédentes, caractérisé en ce qu'une cellule photoélectrique (6) est placée à la sortie du deuxième laser (2).

5. Générateur selon revendication 4, caractérisé en ce que la sortie du deuxième laser (2) et l'entrée de la cellule photoélectrique (6) sont reliées par un circuit demi-onde (4).

6. Générateur selon l'une des revendications 4 ou 5, caractérisé en ce qu'un modulateur optique (9) est monté devant la cellule photoélectrique.

7. Générateur selon l'une des revendications 1 à 3, caractérisé en ce que le premier laser (1) est modulé avec une fréquence correspondant à la fréquence du signal, en ce que le deuxième laser (2) s'enclenche sur une bande latérale déterminée par la modulation et en ce que le signal de sortie du deuxième laser (2) est modulable par un signal de modulation numérique dont la période correspond à la fréquence avec laquelle le premier laser (1) est modulé.

8. Générateur selon revendication 7, caractérisé en ce que le signal de sortie du premier laser (1') est en plus modulé avec un signal apporté, de sorte que le signal à engendrer est lui aussi modulé avec le signal apporté.

9. Générateur selon l'une des revendications 1 à 3, caractérisé en ce que le signal de sortie du premier laser (1') est modulé avec un signal apporté, de sorte que le signal à engendrer est lui aussi modulé avec le signal apporté.

10. Générateur selon l'une des revendications 8 ou 9, caractérisé en ce que le premier laser (1') est modulé directement.

11. Générateur selon l'une des revendications 8 ou 9, caractérisé en ce qu'un modulateur optique externe est prévu pour la modulation.

12. Générateur selon l'une des revendications 6 à 11, caractérisé en ce que le signal de sortie modulé du deuxième laser (2) est à même d'être injecté sur un équipement de transmission optique.

13. Générateur selon l'une des revendications 1 à 3, caractérisé en ce que le signal de sortie du deuxième laser (2) est à même d'être injecté sur un modulateur optique (9) et sur un générateur d'impulsions (12) pour un signal numérique de modulation pour le modulateur optique (9).
